(19) Europäisches Patentamt
European Patent Office
Office européen des brevets

(11) **EP 4 564 242 A1**

(12) **EUROPEAN PATENT APPLICATION**

(43) Date of publication:
**04.06.2025  Bulletin 2025/23**

(21) Application number: **23213354.6**

(22) Date of filing: **30.11.2023**

(51) International Patent Classification (IPC):
*G06N 20/00* (2019.01)    *G05D 1/00* (2024.01)

(52) Cooperative Patent Classification (CPC):
**G06N 20/00; B60W 60/00; G06F 30/15;**
B60W 2556/45; G05D 1/00

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Zenseact AB**
**417 56 Göteborg (SE)**

(72) Inventors:
• **GYLLENHAMMAR, Magnus**
**435 43 Pixbo (SE)**
• **TONDERSKI, Adam**
**426 53 Göteborg (SE)**
• **PETERSSON, Christoffer**
**426 58 Västra Frölunda (SE)**

(74) Representative: **Zacco Sweden AB**
**P.O. Box 5581**
**Löjtnantsgatan 21**
**114 85 Stockholm (SE)**

(54)    **A METHOD FOR DETERMINING A CONSOLIDATION POLICY FOR FORMING A CONSOLIDATED MACHINE LEARNING MODEL**

(57)    The present inventive concept relates to a computer-implemented method (100) for determining a consolidation policy for forming a consolidated machine learning model from a number of local machine learning models of a fleet of vehicles equipped with an automated driving system. The method (100) comprises: obtaining (S102) two or more model updates from one or more vehicles of the fleet of vehicles, wherein each model update is a result of training a local machine learning model of the respective vehicle; consolidating (S106) the two or more model updates according to a candidate consolidation policy, thereby forming a consolidated machine learning model; evaluating (S110) the consolidated machine learning model according to an evaluation criterion; and updating (S114) the candidate consolidation policy in view of the evaluation, thereby forming an updated candidate consolidation policy. It further relates to a device thereof.

Fig. 1

**Description**

TECHNICAL FIELD

The present inventive concept relates to the field of autonomous vehicles. In particular, it is related to methods and devices for determining a consolidation policy for forming a consolidated machine learning model.

BACKGROUND

With the development of technology in recent years, image capturing and processing techniques have become widely used in different fields of technology. In particular, vehicles produced today are commonly equipped with some form of vision or perception system for enabling new functionalities. Moreover, an increasing portion of modern vehicles has advanced driver-assistance systems (ADAS) to increase vehicle safety and more generally road safety. ADAS - which for instance may be represented by adaptive cruise control (ACC), collision avoidance system, forward collision warning, lane support systems, etc. - are electronic systems that may aid a driver of the vehicle. Today, there is ongoing research and development within a number of technical areas associated to both the ADAS and the Autonomous Driving (AD) field. ADAS and AD may also be referred to under the common term Automated Driving System (ADS) corresponding to all of the different levels of automation as for example defined by the SAE J3016 levels (0 - 5) of driving automation. The ADS, or the perception system thereof, commonly relies on machine learning models to some extent.

Continuous learning of these systems are important to provide up-to-date and performant features to the market. One way of doing this is through online learning in the vehicle. In other words, in-vehicle learning can be implemented so as to improve the machine learning model(s) locally at the edge nodes (i.e. the vehicle), as opposed to at a central entity (such as within a remote server). Building on this is so-called federated learning, which is a scheme where a "global" or "central" model is consolidated from "local" models trained at the edge. The remote server is then responsible for aggregating or consolidating model updates from each of the edge nodes into a consolidated model.

While this learning scheme allows efficient use of production vehicle for continuous learning and effectively alleviates problems with both data transmission limitations as well as data privacy, how to use the proposed model updates is not a straight forward task. As each vehicle operates in their own geographic region and experience different scenarios and event during each learning cycle, the updated models from each vehicle will all be different, and have different values for contributing to the performance of the consolidated model. There is therefore need for advancements in this field, in regards to new and improved ways of consolidating the model updates of a federated learning scheme.

SUMMARY

The herein disclosed technology seeks to mitigate, alleviate, or eliminate one or more of the above-identified deficiencies and disadvantages in the prior art to address various problems relating to development of automated driving systems, ADS. In particular, the disclosed technology provides ways for improving model performance of a consolidated machine learning model utilizing a federated learning approach. More specifically, the inventors has realized a new and improved way of determining a consolidation policy through an optimization approach. The determined consolidation policy can improve model performance by the way of combining local model updates from a fleet of vehicles in an optimized way.

Various aspects and embodiments of the disclosed invention are defined below and in the accompanying independent and dependent claims.

According to a first aspect, there is provided a computer-implemented method for determining a consolidation policy for forming a consolidated machine learning model from a number of local machine learning models of a fleet of vehicles equipped with an automated driving system. The method comprises obtaining two or more model updates from one or more vehicles of the fleet of vehicles. Each model update is a result of training a local machine learning model of the respective vehicle. The method further comprises consolidating the two or more model updates according to a candidate consolidation policy, thereby forming a consolidated machine learning model. The method further comprises evaluating the consolidated machine learning model according to an evaluation criterion. The method further comprises updating the candidate consolidation policy in view of the evaluation, thereby forming an updated candidate consolidation policy.

A possible associated advantage of the disclosed technology may be that it can enable improved (or even optimized) federated learning given limitations in learning capacity and what model updates are available. More specifically, it can enable forming of a consolidated model which achieves optimal performance when using a federated learning approach on a fleet of vehicles experiencing diverse operating conditions and situations. Moreover, it can balance effects of different learning procedures when they are to be consolidated into a single model. It may aid in ensuring that new model updates, which may help the model in performing better on previously difficult or rare samples, can be appropriately included in the mixing of model updates.

According to a second aspect, there is provided a computer program product comprising instructions which when the program is executed by a computing device, causes the computing device to carry out the method according to any embodiment of the first aspect. According to a third aspect, there is provided a (non-transitory) computer-readable storage medium. The non-transitory computer-readable storage medium stores one or more programs configured to be executed by one or more processors of a processing system, the one or more programs comprising instructions for performing the method according to any embodiment of the first aspect. Any of the above-mentioned features and advantages of the first aspect, when applicable, apply to the second and third aspect as well. In order to avoid undue repetition, reference is made to the above.

According to a fourth aspect, there is provided a device for determining a consolidation policy for forming a consolidated machine learning model from a number of local machine learning models of a fleet of vehicles equipped with an automated driving system. The device comprises control circuitry. The control circuitry is configured to obtain two or more model updates from one or more vehicles of the fleet of vehicles, wherein each model update is a result of training a local machine learning model of the respective vehicle. The control circuitry is further configured to consolidate the two or more model updates according to a candidate consolidation policy, thereby forming a consolidated machine learning model. The control circuitry is further configured to evaluate the consolidated machine learning model according to an evaluation criterion. The control circuitry is further configured to update the candidate consolidation policy in view of the evaluation, thereby forming an updated candidate consolidation policy. Any of the above-mentioned features and advantages of the previous aspects, when applicable, apply to the fourth aspect as well. In order to avoid undue repetition, reference is made to the above.

The term "non-transitory," as used herein, is intended to describe a computer-readable storage medium (or "memory") excluding propagating electromagnetic signals, but are not intended to otherwise limit the type of physical computer-readable storage device that is encompassed by the phrase computer-readable medium or memory. For instance, the terms "non-transitory computer readable medium" or "tangible memory" are intended to encompass types of storage devices that do not necessarily store information permanently, including for example, random access memory (RAM). Program instructions and data stored on a tangible computer-accessible storage medium in non-transitory form may further be transmitted by transmission media or signals such as electrical, electromagnetic, or digital signals, which may be conveyed via a communication medium such as a network and/or a wireless link. Thus, the term "non-transitory", as used herein, is a limitation of the medium itself (i.e., tangible, not a signal) as opposed to a limitation on data storage persistency (e.g., RAM vs. ROM).

The disclosed aspects and preferred embodiments may be suitably combined with each other in any manner apparent to anyone of ordinary skill in the art, such that one or more features or embodiments disclosed in relation to one aspect may also be considered to be disclosed in relation to another aspect or embodiment of another aspect.

Further embodiments are defined in the dependent claims. It should be emphasized that the term "comprises/comprising" when used in this specification is taken to specify the presence of stated features, integers, steps, or components. It does not preclude the presence or addition of one or more other features, integers, steps, components, or groups thereof.

These and other features and advantages of the disclosed technology will, in the following, be further clarified with reference to the embodiments described hereinafter.

BRIEF DESCRIPTION OF THE DRAWINGS

The above aspects, features and advantages of the disclosed technology, will be more fully appreciated by reference to the following illustrative and non-limiting detailed description of example embodiments of the present disclosure, when taken in conjunction with the accompanying drawings, in which:

Figure 1 is a schematic flowchart representation of a method for determining a consolidation policy for forming a consolidated machine learning model from a number of local machine learning models, in accordance with some embodiments.

Figure 2 is a schematic illustration of a device for determining a consolidation policy for forming a consolidated machine learning model from a number of local machine learning models, in accordance with some embodiments.

Figure 3 is a schematic illustration of a vehicle in accordance with some embodiments.

Figure 4 is a schematic illustration of a system, in accordance with some embodiments.

Figure 5 illustrates, by way of example, a flowchart for updating a consolidation policy according to some embodiments.

DETAILED DESCRIPTION

The present disclosure will now be described in detail with reference to the accompanying drawings, in which some example embodiments of the disclosed technology are shown. The disclosed technology may, however, be embodied in other forms and should not be construed as limited to the disclosed example embodiments. The disclosed example embodiments are provided to fully convey the scope of the disclosed technology to the skilled person. Those skilled in the art will appreciate that the steps, services and functions explained herein may be implemented using individual hardware circuitry, using software functioning in conjunction with a programmed microprocessor or general purpose computer, using one or more Application Specific Integrated Circuits (ASICs), using one or more Field Programmable Gate Arrays (FPGA) and/or using one or more Digital Signal Processors (DSPs).

It will also be appreciated that when the present disclosure is described in terms of a method, it may also be embodied in apparatus comprising one or more processors, one or more memories coupled to the one or more processors, where computer code is loaded to implement the method. For example, the one or more memories may store one or more computer programs that causes the apparatus to perform the steps, services and functions disclosed herein when executed by the one or more processors in some embodiments.

It is also to be understood that the terminology used herein is for purpose of describing particular embodiments only, and is not intended to be limiting. It should be noted that, as used in the specification and the appended claim, the articles "a", "an", "the", and "said" are intended to mean that there are one or more of the elements unless the context clearly dictates otherwise. Thus, for example, reference to "a unit" or "the unit" may refer to more than one unit in some contexts, and the like. Furthermore, the words "comprising", "including", "containing" do not exclude other elements or steps. It should be emphasized that the term "comprises/comprising" when used in this specification is taken to specify the presence of stated features, integers, steps, or components. It does not preclude the presence or addition of one or more other features, integers, steps, components, or groups thereof. The term "and/or" is to be interpreted as meaning "both" as well and each as an alternative.

It will also be understood that, although the term first, second, etc. may be used herein to describe various elements or features, these elements should not be limited by these terms. These terms are only used to distinguish one element from another. For example, a first element could be termed a second element, and, similarly, a second element could be termed a first element, without departing from the scope of the embodiments. The first element and the second element are both elements, but they are not the same element.

As used herein, the wording "one or more of" a set of elements (as in "one or more of A, B and C" or "at least one of A, B and C") is to be interpreted as either a conjunctive or disjunctive logic. Put differently, it may refer either to all elements, one element or combination of two or more elements of a set of elements. For example, the wording "one or more of A, B and C" may be interpreted as A or B or C, A and B and C, A and B, B and C, or A and C.

Throughout the present disclosure, reference is made to a machine learning model (may also be referred to as machine-learning algorithm, network, neural network, deep learning network and so forth) which herein refers to any computational system or algorithm that is trained on data to make predictions or decisions, e.g. by learning patterns and relationships from training data and applying that knowledge on new input data.

The machine learning model may be a model configured to process any type of sensor data of a vehicle, such as image data, LIDAR data, RADAR data, etc. The machine learning model may e.g. be a perception model, an object detection model, an object classification model, an object tracking model, a lane estimation model, a free-space estimation model, a trajectory prediction model, an obstacle avoidance model, a path planning model, a scene classification model, a traffic sign classification model etc. Moreover, the machine learning model may encompass different architectures, including but not limited to convolutional neural networks (CNNs), recurrent neural networks (RNNs), and other existing or future alternatives.

The deployment of machine learning models typically involves a training phase where the model learns from labeled or unlabeled training data to achieve accurate predictions during a subsequent inference phase. The training data (as well as input data during inference) may e.g. be an image, or sequence of images, LIDAR data (i.e. a point cloud), radar data etc. Furthermore, the training/input data may comprise a combination or fusion of one or more different data types. The training/input data may for instance comprise both an image depicting an annotated object and corresponding LIDAR point cloud comprising the same annotated object.

The machine learning models may be implemented in some embodiments using publicly available suitable software development machine learning code elements, for example, such as those which are available in Pytorch, TensorFlow, and Keras, or in any other suitable software development platform, in any manner known to be suitable to someone of ordinary skill in the art.

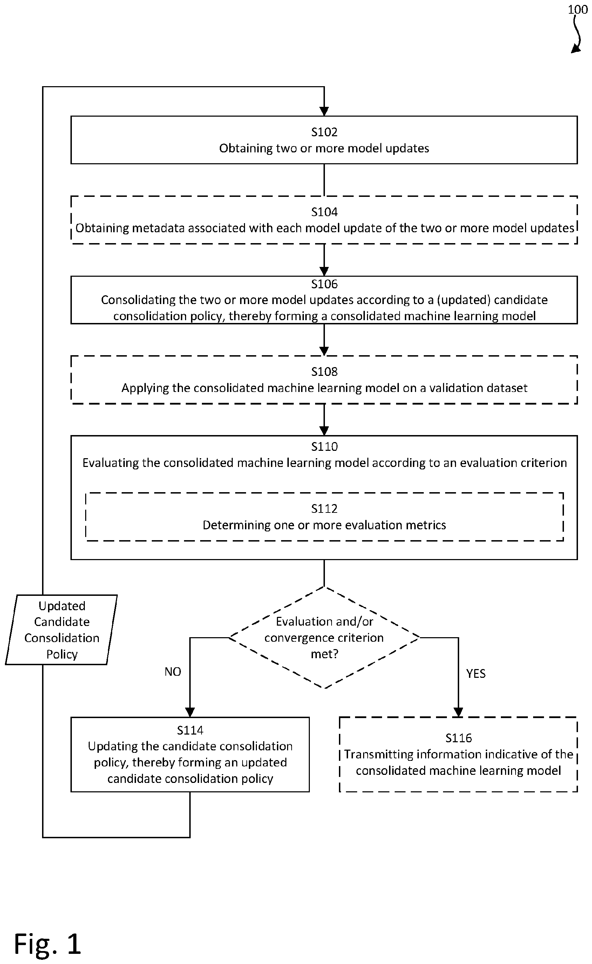

A method for determining a consolidation policy for forming a consolidated machine learning model (sometimes referred to as just "consolidated model") from a number of local machine learning models will, as well as other related aspects thereof, will in the following be described with reference to Fig. 1 to 5. In short, the process can be seen as an optimization problem where the objective is to find the best policy for forming the consolidated model. This optimization can be guided through evaluation of different candidates which can be continuously refined until the best policy is found.

As described above, it is possible to leverage online learning of machine learning models in vehicles of a fleet of vehicles to forming a "central" or "global" model, herein referred to as a consolidated machine learning model, or just consolidated model. The consolidated model is thus formed by a combination of a number of local models trained at the edge (i.e. in the vehicles). This is commonly referred to as federated learning. A central server is typically used to collect the local models, and combining (or aggregating) them to form the consolidated model. The idea is that the consolidated model, by being a combination of several local models, will have better performance than what could be achieved by more traditional learning schemes of training just a single model. This is partly because the local models which contribute to the consolidated model all have different experiences, and has learnt from different data distributions. This diversity in data sources helps the consolidated model generalize better to various patterns and conditions, which can lead to improved overall performance.

Federated learning offers several additional advantages as well. Firstly, it can improve privacy and security as it enables the local models to be trained locally on the device, without having to transmit any raw and potentially sensitive data to the central server. This improved both privacy, as the data stays on the local device, and security, as the risk of unauthorized access during data transmission can be reduced. Secondly, it can offer better bandwidth efficiency, since only the model updates are sent to the server, instead of the raw data. Thus, federated learning can reduce the amount of data transferred over the network. Moreover, the decentralized approach utilizing edge computing can lead to faster model updates and reduced latency. It may further come with advantages relating to resilience to device failures, data governance, robustness and redundancy.

The outstanding question which the inventors sets out to solve, is how to combine the local models in a way that optimizes the performance of the consolidated model given a finite number of model updates. Considering the limited learning capacity of machine learning models, stemming e.g. from in-vehicle computation and latency limitations, how to balance the use of the different model updates can play a big part in achieving a performant consolidated model.

Common ways of consolidating a model using federated learning is through simply averaging the model updates of the local models - or in a slightly more sophisticated way - through weighted averaging. In the latter case, the weights may for instance be derived based upon the number of new samples each model update has incorporated. While this effectively incorporates the updates from all entities, in the federation it might be troublesome considering that the data from the different entities might contribute to the final performance of the consolidated model in varying degrees, which might impact the performance of the consolidated model when relying on a fixed (simple) protocol for weighted averaging. Instead, the presently disclosed technology addresses this problem through a new and improved way, utilizing an optimization regime for determining a consolidation policy which helps to achieve an optimal consolidated model over a search space comprising the number of local model updates available. The search space is explored to find a candidate for the optimal consolidation policy. A consolidated model is then formed based on the candidate consolidation policy and subsequently evaluated. Based on the outcome of the evaluation, the candidate consolidation policy may be updated. These steps can be iterated in an optimization loop, until an evaluation criterion and/or a convergence criterion is met. After the iteration, the then final candidate consolidation policy can be used to form the consolidated model to be used in production. As such, the present technology proposed herein provides a way towards finding the optimal consolidated model from a learning loop that depends on federated learning. In the following, the proposed method will be explained in more detail.

It is to be noted that the federated learning as described above, may be referred to as a centralized federated learning scheme. However, in some embodiments the need for a central entity may be omitted and the edge devices (e.g. a fleet of vehicles) may be configured to coordinate themselves to obtain the global model, a so called decentralized federated learning scheme. In the following the description is mainly given in reference to a centralized federated learning scheme. It is however presumed that those skilled in the art would readily appreciate how to implement the teachings herein to a decentralized federated learning scheme, and that the scope conveyed by the invention disclosed herein encompasses such a realization. Moreover, it should be noted that the term "global" does not necessarily imply "worldwide", in the present context, but should instead be construed as something that is "shared" among a plurality of "local" entities.

It should be noted that the wordings "optimal", "optimization", or similar, should be understood as something being made as "good as possible" within some restrictions. The restrictions may be a time restriction defined e.g. by the evaluation criterion and/or convergence criterion. The restrictions may further pertain to computational resources or numerical approximations. It may further be "optimal" or "optimized" in the sense that it is determined based on optimization algorithms, as known in the art. An "optimal consolidation policy" or "optimal model performance" and the like, need not to be the single-most optimal solution (i.e. the global min/-max), but could rather be a solution towards the single-most optimal solution.

Figure 1 is a schematic flowchart representation of a method 100 for determining a consolidation policy for forming a consolidated machine learning model from a number of local machine learning models. The number of local machine learning models may be deployed in a respective vehicle of a fleet of vehicles equipped with an automated driving system, ADS. More specifically, the local models may be part of the ADS of the vehicles. Forming the consolidation model (or global model) from the number of local models can, as stated above, be seen as a federated learning scheme.

The method 100 may be performed offline, e.g.

by a server. The server may also be referred to as remote server, cloud server, central server, back-office server, fleet server, or back-end server. In such case, a centralized federated learning scheme can be achieved. Alternatively, the method 100 may be performed by a vehicle (or a number of vehicles) of the fleet of vehicles. In such case, a decentralized federated learning scheme is achieved. This can be seen as a swarm approach (or setup) of implementing the herein disclosed techniques.

Below, the different steps of the method 100 are described in more detail. Even though illustrated in a specific order, the steps of the method 100 may be performed in any suitable order as well as multiple times. Thus, although Fig. 1 may show a specific order of method steps, the order of the steps may differ from what is depicted. In addition, two or more steps may be performed concurrently or with partial concurrence. Such variation will depend on the software and hardware systems chosen and on designer choice. For example, the steps denoted S102 and S104 can be performed irrespectively of each other, in any order. All such variations are within the scope of the invention. Likewise, software implementations could be accomplished with standard programming techniques with rule-based logic and other logic to accomplish the various steps. Further variants of the method 100 will become apparent from the present disclosure. The above mentioned and described embodiments are only given as examples and should not be limiting to the present invention. Other solutions, uses, objectives, and functions within the scope of the invention as claimed below described patent claims should be apparent for the person skilled in the art.

The method 100 comprises obtaining S102 two or more model updates from one or more vehicles of the fleet of vehicles. In other words, at least two model updates from at least one vehicle may be obtained S102.

The term "obtaining" is throughout the present disclosure to be interpreted broadly and encompasses receiving, retrieving, collecting, acquiring, and so forth directly and/or indirectly between two entities configured to be in communication with each other or further with other external entities. However, in some embodiments, the term "obtaining" is to be construed as determining, deriving, forming, computing, etc. In other words, obtaining two or more model updates from one or more vehicles of the fleet of vehicles may comprise receiving the two or more model updates from the respective vehicle. Thus, each vehicle may transmit their respective model update(s) to the server carrying of the method 100. In some embodiments, e.g. when the method 100 is performed by a vehicle of the fleet of vehicles, the respective model update(s) may be transmitted to said vehicle. Said vehicle may then perform the remaining steps of the method 100, as further described below. Or perform some of the later steps, and then transmit data to the server for performing the remaining steps.

Each model update is a result of training a local machine learning model of the respective vehicle. More specifically, the model update is a result of an in-vehicle learning process in which the local machine learning model is trained (or re-trained) on a number of training samples collected by said vehicle (e.g. through on-board sensors). The model update should herein be understood as any information indicative of the corresponding updated local model. For example, each model update may comprise updated model parameters. The updated model parameters being updated as part of training of the respective local model. By obtaining (e.g. through data transmission from the vehicle(s)) the model updates as updated model parameters, an efficient use of bandwidth can be achieved. It is however to be noted that the model update may comprise the updated local model itself, or an updated part of it.

The two or more model updates may come from different vehicles. As each vehicle in the fleet will operate in different geographic regions, at different times of day, and experience different situations and rare events during operation, the local models will have experienced heterogeneous or differently distributed data. Thus, the model updates from each vehicle will be based on data having a varying degree of value in terms of increasing the performance of the consolidated model. Alternatively, or in combination, the two or more model updates may come from a same vehicle, but from a different points in time (i.e. from different learning cycles). As the same vehicle will experience different situations during different points in time, the diversity in data on which the local model is trained can be achieved also by taking model updates of the same local model from these different points in time (i.e. from different learning cycles). Thus, obtaining S102 the two or more model updates may be performed over a plurality of learning cycles for the local models, before the two or more model updates are consolidated S106 to form the consolidated model. The consolidation policy may then further take into account which learning cycle each model update is from. For example, model updates from an earlier learning cycle may be associated with less relevance than a model update from a more recent learning cycle.

The wording "learning cycle" as used herein, refers to the process of obtaining a model update. In other words, one learning cycle may correspond to the time during which new training samples are collected, and the local model is trained on said training samples. The learning cycle then ends when this process is terminated and the model update is obtained. The training process can e.g. be terminated when the updated local model fulfils a certain criterion (such as a convergence criterion), after a defined amount of time, or after a certain amount of new training samples having been incorporated in the updated model. The learning cycles may be synchronized across the fleet of vehicles, such that the server obtains the two or more model updates around a same time. Alternatively, the learning cycles may be individual, for the vehicles of the fleet of vehicles.

The method 100 further comprises consolidating S106 the two or more model updates according to a candidate consolidation policy. Thereby a consolidated machine learning model (or more specifically a candidate consolidated machine learning model) is formed. Forming the consolidated model by consolidating S106 the two or more model updates (or in general, how a plurality or models can be merged into one) may be done by combining the model parameters of the local models into one set of model parameters for the consolidated mode, according to the consolidation policy. In some embodiments, the consolidated model may be formed in a vehicle, which then transmits the consolidated model (of information indicative thereof) to the server.

The (candidate) consolidation policy may comprise a set of mixing weights. Each mixing weight of the set of mixing weights may be associated with a model update of the two or more model updates. Thus, the consolidation policy defines how the different model updates should be combined to form the consolidated model. The mixing weight may be used to give different weight to different model updates. More specifically, the mixing weight may be used to give different weight to different sets of model parameters of the respective local models.

By the wording "candidate", as in "candidate consolidation policy" or "candidate consolidated machine learning model", it is herein meant a potential candidate for the "optimal" solution. Thus, the candidate consolidation policy can be seen as a potential consolidation policy which could be used as the consolidation policy for forming the final consolidated model.

The principles of the proposed method 100 can then provide for ways for updating the candidate consolidation policy until a desirable consolidation policy (e.g. in the sense that it can result in a well-performing model) has been obtained. In other words, through iteration (i.e. repeating the process for a number of iterations (also referred to as loops)), the candidate consolidation policy can be refined towards becoming the optimal consolidation policy. The candidate consolidation policy used in step S106 may thus be a consolidation policy determined as a result of a previous iteration. Alternatively, the candidate consolidation policy may be an initial consolidation policy set as a starting point for the iteration. How the method may be iterated will be further explained in the following.

The method 100 further comprises evaluating S110 the consolidated machine learning model according to an evaluation criterion. Evaluating S110 the candidate consolidated model may provide information about how well the model performs after being formed according to the candidate consolidation policy. The evaluation criterion may for instance provide information indicative of a performance of the consolidated model, or any other suitable metric. The evaluation criterion may comprise a plurality of sub-criterion. In other words, the consolidated machine learning model may be evaluated S110 according to a set of evaluation criteria. Each sub-criterion (i.e. each evaluation criterion of the set of evaluation criteria) may provide information indicative of different performance aspects of the consolidated machine learning model. The evaluation criterion (or any sub-criterion thereof) may for instance comprise classification metrics, such as accuracy, false positive/negative rate, precision, recall, logarithmic loss, F1-score etc. Alternatively, or in combination, the evaluation criterion (or any sub-criterion thereof) may comprise regression testing metrics, such as coefficient of determination (or R-squared), mean squared error, mean absolute error, etc. In case the method 100 are performed iteratively, the evaluation criterion may involve comparing the consolidated machine learning model to a machine learning model consolidated in a previous iteration according to a previous candidate consolidation policy. In other words, the performance of the consolidated machine learning model may be compared to a previously consolidated machine learning model of a previous iteration. By the wording "regression testing metrics", it is herein meant metrics obtained from a regression testing procedure, in which previous test cases, which previous versions of the consolidated model has been tested on, are included. For example, previous test cases of which the previous version of the consolidated model (i.e. formed according to a previous candidate consolidation policy) has performed badly can be run to see if the updated consolidated model (i.e. trained with the updated candidate consolidation policy) performs better. More specific ways of performing the evaluation S110 will be given below. In some embodiments, the evaluation step may be run for several consolidation models formed by different candidate consolidation policies in parallel, to evaluate several models at once. This may especially be relevant when using in-vehicle evaluation, to effectively reduce the time for finding the next optimal consolidated model.

The method 100 further comprises updating S114 the candidate consolidation policy in view of the evaluation, thereby forming an updated candidate consolidation policy. In other words, the candidate consolidation policy may be updated in view of the evaluation criterion. The candidate consolidation policy may be updated S114 in view of the evaluation such that the updated candidate consolidation policy potentially lead to better performance of the model. The wording "in view of the evaluation" may be understood as based on a fulfilment of the evaluation criterion. More specifically, in case the evaluation criterion is fulfilled, the candidate consolidation policy may be kept as it is, whereas if not fulfilled, the candidate consolidation policy may be adjusted in any way to compensate for this. In the former case, the method 100 may be terminated, and the candidate consolidation policy (and candidate consolidated model) may be used as the final consolidation policy (and final consolidated model). In the latter case, the updated candidate consolidation policy may be used in a subsequent loop of repeating the method 100.

In some embodiments, the method 100 further comprises obtaining S104 metadata associated with each obtained model update. The metadata may be obtained S104 together with obtaining S102 the two or more model updates. The step of updating S114 the candidate consolidation policy may then be based on the obtained metadata. Or put differently, the consolidation policy may be defined by the metadata so as to combine the local models based on their respective metadata. Using metadata can further reduce the search space, which in turn may improve the convergence and reduce the search efforts needed to reach such convergence. The possible mixing weights defining the consolidation policy may thus be set based on the metadata. A model update which according to its metadata appears to be of higher relevance for achieving a performant consolidated model, may thus be given a higher weight. In some embodiments, the metadata may be further used in the step of evaluating S110 the consolidated machine learning model.

The metadata may for example comprise information indicative of what the respective local model has experienced during its training, conditions of the training, how much new data samples it has been trained on, states of internal systems (e.g. active or not, potential error codes, etc.) of the vehicle during training and/or collection of data samples etc. The experiences of the local models may e.g. comprise information about driving scenarios (e.g. highway driving, city driving, traffic jams), objects detected (e.g. pedestrians, certain types of vehicles), etc. The conditions of the training may e.g. comprise information about where (i.e. geographical location), and/or when (e.g. time-of-day) the training (or more specifically the collection of training samples used in the training) occurred.

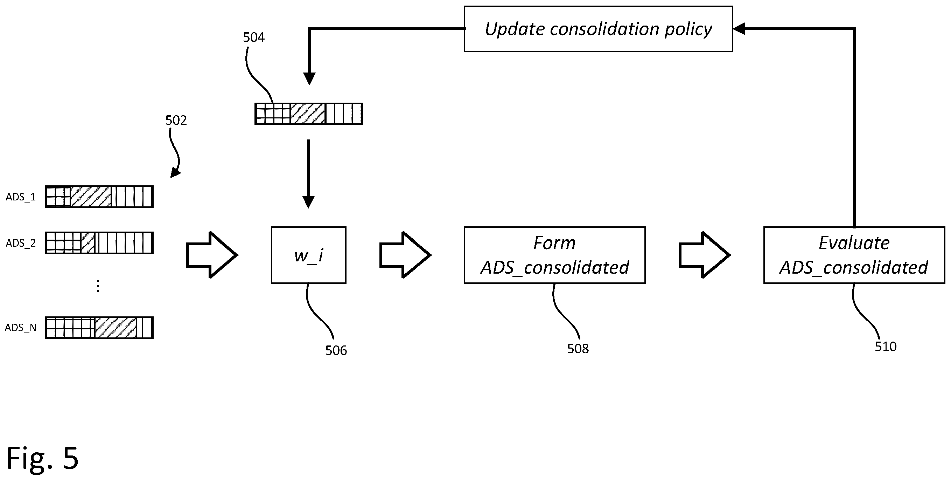

Figure 5 illustrates, by way of example, a flowchart of how the consolidation policy may be updated. As input, a number of model updates 502, *ADS_1* to *ADS_N* are provided. The model updates are herein illustrated by three boxes with different patterns, where each pattern corresponds to samples associated with certain metadata, and the width of the boxes indicates a number of samples associated with each metadata. A candidate consolidation policy 504 is further provided. The candidate consolidation policy can also be defined by metadata, and an amount of data samples for each metadata. The candidate consolidation policy defined by metadata can be transformed to a set of mixing weights 506, herein denoted *w_i*, where *i* goes from 1 to *N*. The set of mixing weights may comprise one weight associated with each model update. Based on the set of mixing weights 506, a candidate consolidated model (*ADS_consolidated*) can be formed, in block 508. The candidate consolidated model can be formed according to the formula:

$$ADS\_consolidated = \sum_i w\_i * ADS\_i.$$

The consolidated model, *ADS_consolidated,* may then be evaluated in block 510. Based on the evaluation, the candidate consolidation policy may either be updated (as shown herein), or the consolidated model may be outputted as the final consolidated model.

Moving on, the candidate consolidation policy may be updated S114 by an optimization algorithm. In other words, the updated candidate consolidation policy may be determined using an optimization algorithm. Put differently, the process of determining the consolidation policy may be performed using an optimization algorithm, i.e. select candidate consolidation policy from search space, form consolidated model according to candidate consolidation policy, evaluate consolidated model, and update candidate consolidation policy based on the evaluation. The optimization algorithm may for example be random search, naive random search, grid search, stochastic optimization such as genetic algorithm, Bayesian optimization, swarm optimization, or reinforcement learning.

If the evaluation criterion is fulfilled, the method 100 may be terminated, and the candidate consolidation policy may be stored as the determined consolidation policy for forming the final consolidated machine learning model. The final consolidated model may then be deployed in the fleet of vehicles. Thus, the method 100 may comprise storing the candidate consolidation policy as the determined consolidation policy, in response to the evaluation criterion (and/or convergence criterion) being met. Put differently, in case the evaluation criterion is fulfilled, the candidate consolidation policy may be kept as it is. In other words, the updated candidate consolidation policy may be selected as the current candidate consolidation policy. This will be further explained in the following.

As stated above, the steps of the method 100 (denoted S102 to S114) may be repeated for the updated candidate consolidation policy until the evaluation criterion and/or a convergence criterion of the consolidated machine learning model is met. In other words, the method 100 may be repeated with the updated candidate consolidation policy as a new candidate consolidation policy for the subsequent loop/iteration. The step of updating S114 the candidate consolidation policy may thus be performed in response to the evaluation criterion and/or the convergence criterion has not been met. Otherwise, the iteration may be terminated. Thus, in response to the evaluation criterion and/or the convergence criterion are met, the candidate consolidation policy may be selected as the determined consolidation policy to be used for forming the consolidated model. By repeating the steps the candidate consolidation policy can be continuously refined until the evaluation criterion and/or convergence criterion has been met. Put differently, the proposed solution provides for updating the candidate consolidation policy based on the evaluation criterion in a loop to continuously refine the candidate consolidation policy such that the performance of the consolidation model can be improved.

In response to the evaluation criterion and/or the convergence criterion being met, the method 100 may further comprise forming the consolidated machine learning model based on the determined consolidation policy. Alternatively, the consolidated model of the last iteration may be selected as the consolidated model to be used in production (i.e. deployed in the fleet). The method 100 may thus be a method for forming a consolidated model.

In response to the evaluation criterion and/or the convergence criterion being met, the method 100 may further comprise transmitting S116 information indicative of the consolidated machine learning model to one or more vehicles of the fleet of vehicles. In other words, the consolidated model can be deployed in the fleet. The information indicative of the consolidated machine learning model may comprise the model itself, or rather a copy of the model. Alternatively, the information may comprise a model update comprising updated model parameters. Alternatively, or in combination, the information may comprise a delta update, specifying the changes in the model (or its parameters) compared to a previously deployed model.

In some embodiments, the evaluation criterion (on its own) may be used as trigger to terminate the loop. In some embodiments, both the evaluation criterion and the convergence criterion may be used as triggers to terminate the loop. The loop may then be terminated if both, or if just one of the evaluation criterion and the convergence criterion are met. In some embodiments, the convergence criterion (on its own) may be used as trigger to terminate the loop. Different ways of implementing the trigger to terminate the loop may serve different purposes. The evaluation criterion may be advantageous as a trigger e.g. if model performance is of most relevance. If instead it is desirable to have a more robust model, the convergence criterion may be advantageous. If both are of importance, a combination thereof may be preferable.

The convergence criterion may be any suitable convergence criterion known in the art. For example, the convergence criterion may be a threshold value for a loss function. In another example, the convergence criterion may be to monitor changes in model parameters (such as the model weights). If the changes in model parameters between iterations become small, it may be an indication of convergence. In yet another example, the convergence criterion may be to monitor changes in model performance on a validation set. If the change in model performance between iterations become small, it may also be an indication of convergence. It is to be noted that the examples of convergence criterion mentioned above, as well as other possible criteria, can be combined. Thus, the convergence criterion may comprise one or more convergence metrics. Each convergence metric may correspond to a different way of measuring convergence. The convergence criterion may then be met when the one or more convergence metrics reaches a respective threshold value.

Evaluating S110 the consolidated machine learning model may comprise determining S112 one or more evaluation metrics associated with the evaluation criterion. The candidate consolidation policy may then be updated S114 based on a comparison of the one or more evaluation metrics with a respective threshold value. The evaluation metrics may be seen as numeric values based on which the evaluation criterion can be formulated. The evaluation metrics may correspond to the different sub-criteria of the evaluation criterion referred to above. The evaluation criterion may be met when the one or more evaluation metrics reaches the respective threshold value. By evaluating the consolidated machine learning model based on the one or more evaluation metrics, a progress of the model over time (or rather over iterations) can be evaluated. As the method 100 traverses the space of possible candidate consolidation policies, a directionality of the evaluation metrics can thus be observed. Based on this, the candidate consolidation policy can then be updated.

In some embodiments, the method 100 further comprises applying S108 the consolidated machine learning model on a validation dataset. Put differently, the step of evaluating S110 the consolidated machine learning model may comprise applying S108 the consolidated machine learning model on the validation dataset. In other words, the consolidated machine learning model may be run on the validation dataset. The evaluation criterion may then be indicative of a performance of the consolidated machine learning model on the validation dataset. The validation dataset may be selected as a pre-existing dataset. The pre-existing dataset may e.g. be stored in the server performing the method. The pre-existing dataset may e.g. be a regulatory baseline dataset, or a dataset of a set of defined test scenarios that the model should be evaluated on to fulfill certain regulations, such as the so called EURO-NCAP. The step of evaluating S110 the consolidated model may thus be performed offline, at the server.

It is however to be appreciated that the method 100, or at least parts of the method 100 may be performed online, in a vehicle. Performing the entire method 100 in a vehicle would then correspond to a decentralized federated learning scheme, as described above. As an example of a way of performing parts of the method 100, one or more vehicles may perform the step (or parts of the step) of evaluating S110 the consolidated model.

The validation dataset may be formed by obtaining a validation data sample, and storing the validation data sample to the validation dataset, in response to the validation data sample fulfilling one or more validation triggers. The validation data sample(s) may be obtained by being collected by onboard sensors of the vehicle. Then, the vehicle may check whether the validation data sample(s) fulfills the one or more validation triggers. If so, the validation data sample(s) may be stored to the validation dataset. This may be repeated until the validation.

A certain number of validation data samples of each validation trigger, or combination of validation triggers, can be collected and stored, until the validation dataset fulfills a validation dataset distribution (or such that the aggregated validation dataset has a certain distribution across the one or more validation triggers). If performed in the server, the validation data sample may be obtained from vehicles of the fleet of vehicles having collected the validation data sample by onboard sensors. Then the consolidated machine learning model may be applied S108 to the validation data samples fulfilling the one or more validation triggers (or belonging to the validation dataset). Alternatively, the vehicle may store the validation data samples which are found to fulfill the one or more validation triggers and/or transmit them to the server for forming the validation data set. It is to be appreciated that the check for whether a validation data sample fulfills the one or more validation triggers (and/or aggregation of the validation dataset such that it has a certain distribution across the one or more validation triggers) may as well be performed in the server. Thus, the vehicle may transmit any data samples, or just data samples fulfilling the one or more validation triggers.

Moreover, a set of validation triggers may be distributed among vehicles of the fleet of vehicles, together with the consolidated machine learning model. The set of validation triggers should herein be seen as conditions indicating what data samples is to be included in the evaluation. The validation triggers may e.g. be defined through metadata, such as the metadata described above. In response to a vehicle encountering a scenario fulfilling a validation trigger (i.e. a validation data sample), the vehicle may transmit sensor data pertaining to that scenario to the server. Alternatively, of in combination, the consolidated machine learning model may be evaluated (in the vehicle) on that scenario in parallel with the operational platform of the vehicle (i.e. in so-called shadow-mode testing). The evaluation metrics may be stored in the vehicle, and transmitted to the server. The server may then (if needed) update the candidate consolidation policy, based on the evaluation metrics, and later form a new consolidated machine learning model based on the updated candidate consolidation policy.

It is to be noted that evaluating S110 the machine learning model may be done both using the pre-existing validation dataset, and using dynamically collected validation data samples based on validation triggers, as explained above.

Executable instructions for performing these functions are, optionally, included in a non-transitory computer-readable storage medium or other computer program product configured for execution by one or more processors.

Generally speaking, a computer-accessible medium may include any tangible or non-transitory storage media or memory media such as electronic, magnetic, or optical media-e.g., disk or CD/DVD-ROM coupled to computer system via bus. The terms "tangible" and "non-transitory," as used herein, are intended to describe a computer-readable storage medium (or "memory") excluding propagating electromagnetic signals, but are not intended to otherwise limit the type of physical computer-readable storage device that is encompassed by the phrase computer-readable medium or memory. For instance, the terms "non-transitory computer-readable medium" or "tangible memory" are intended to encompass types of storage devices that do not necessarily store information permanently, including for example, random access memory (RAM). Program instructions and data stored on a tangible computer-accessible storage medium in non-transitory form may further be transmitted by transmission media or signals such as electrical, electromagnetic, or digital signals, which may be conveyed via a communication medium such as a network and/or a wireless link.

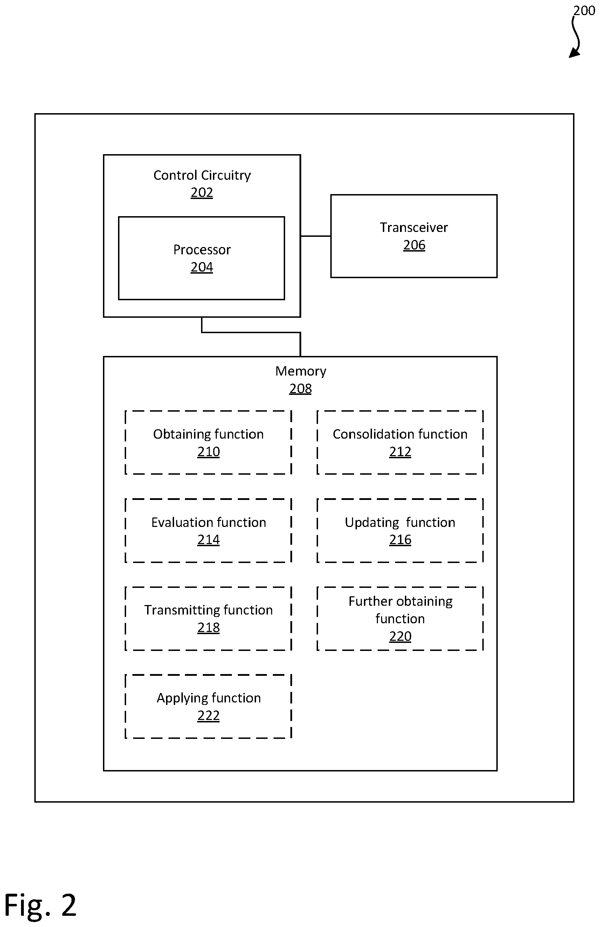

Figure 2 is a schematic illustration of a device 200, for determining a consolidation policy for forming a consolidated machine learning model from a number of local machine learning models, in accordance with some embodiments. The device 200 may be configured to perform the method 100 as described in connection with Fig. 1.

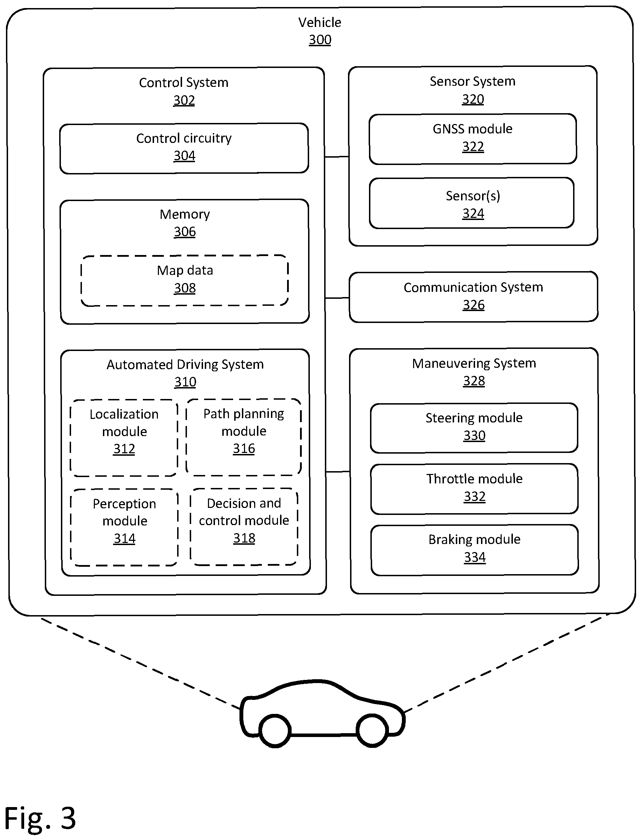

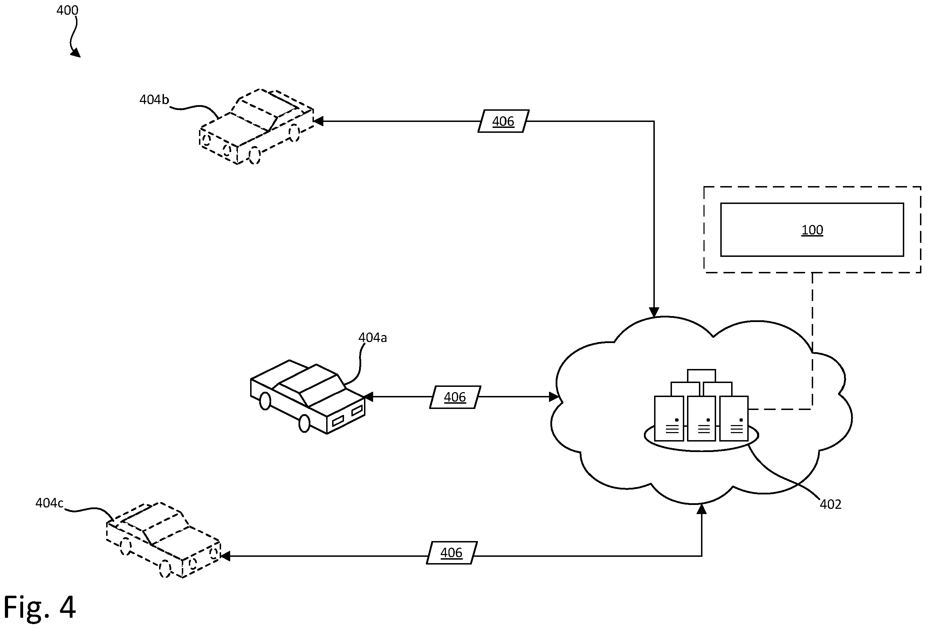

The device 200 as described herein refers to any computer system or general computing device. The device 200 may be a server (may also be referred to as remote server, cloud server, central server, back-office server, fleet server, or back-end server) or a networked device configured to provide various computing services, data storage, processing capabilities, or resources to clients or users over a communication network. In the present case, the wording "clients" refers to connected vehicles (such as the vehicle 300 described below) of a fleet of vehicles. The server may then e.g. be the server 602 as described below in connection with Fig. 4. Alternatively, the device 200 may be provided as part of a vehicle, such as the vehicle described below in connection with Fig. 3. Even though the device 200 is herein illustrated as one device, the device 200 may be a distributed computing system, formed by a number of different computational devices.

The device 200 comprises control circuitry 202. The control circuitry 202 may physically comprise one single circuitry device. Alternatively, the control circuitry 202 may be distributed over several circuitry devices.

As shown in the example of Fig. 2, the device 200 may further comprise a transceiver 206 and a memory 208. The control circuitry 202 being communicatively connected to the transceiver 206 and the memory 208. The control circuitry 202 may comprise a data bus, and the control circuitry 202 may communicate with the transceiver 206 and/or the memory 208 via the data bus.

The control circuitry 202 may be configured to carry out overall control of functions and operations of the device 200. The control circuitry 202 may include a processor 204, such as a central processing unit (CPU), microcontroller, or microprocessor. The processor 204 may be configured to execute program code stored in the memory 208, in order to carry out functions and operations of the device 200. The control circuitry 202 is configured to perform the steps of the method 100 as described above in connection with Fig. 1. The steps may be implemented in one or more functions stored in the memory 208.

The transceiver 206 is configured to enable the device 200 to communicate with other entities, such as vehicles or other servers. The transceiver 206 may both transmit data from and receive data to the device 200.

The memory 208 may be a non-transitory computer-readable storage medium. The memory 208 may be one or more of a buffer, a flash memory, a hard drive, a removable media, a volatile memory, a non-volatile memory, a random access memory (RAM), or another suitable device. In a typical arrangement, the memory 208 may include a non-volatile memory for longterm data storage and a volatile memory that functions as system memory for the device 200. The memory 208 may exchange data with the circuitry 202 over the data bus. Accompanying control lines and an address bus between the memory 208 and the circuitry 202 also may be present.

Functions and operations of the device 200 may be implemented in the form of executable logic routines (e.g., lines of code, software programs, etc.) that are stored on a non-transitory computer readable recording medium (e.g., the memory 208) of the device 200 and are executed by the circuitry 202 (e.g., using the processor 204). Put differently, when it is stated that the circuitry 202 is configured to execute a specific function, the processor 204 of the circuitry 202 may be configured execute program code portions stored on the memory 208, wherein the stored program code portions correspond to the specific function. Furthermore, the functions and operations of the circuitry 202 may be a stand-alone software application or form a part of a software application that carries out additional tasks related to the circuitry 202. The described functions and operations may be considered a method that the corresponding device is configured to carry out, such as the method 100 discussed above in connection with

Fig. 1. In addition, while the described functions and operations may be implemented in software, such functionality may as well be carried out via dedicated hardware or firmware, or some combination of one or more of hardware, firmware, and software. In the following, the function and operations of the device 200 is described.

The control circuitry 202 is configured to obtain two or more model updates from one or more vehicles of the fleet of vehicles, wherein each model update is a result of training a local machine learning model of the respective vehicle. This may be performed e.g. by execution of an obtaining function 210.

The control circuitry 202 is further configured to consolidate the two or more model updates according to a candidate consolidation policy, thereby forming a consolidated machine learning model. This may be performed e.g. by execution of a consolidation function 212.

The control circuitry 202 is further configured to evaluate the consolidated machine learning model according to an evaluation criterion. This may be performed e.g. by execution of an evaluation function 214.

The control circuitry 202 is further configured to update the candidate consolidation policy in view of the evaluation, thereby forming an updated candidate consolidation policy. This may be performed e.g. by execution of an updating function 216.

The control circuitry 202 may be configured to repeat the above steps for the updated candidate consolidation policy until the evaluation criterion and/or a convergence criterion is met.

The control circuitry 202 may be further configured to, in response to the evaluation criterion and/or the convergence criterion being met, transmit information indicative of the consolidated machine learning model to one or more vehicles of the fleet of vehicles. This may be performed e.g. by execution of a transmitting function 218.

The control circuitry 202 may be further configured to obtain metadata associated with each model update. This may be performed e.g. by execution of a further obtaining function 220. Updating the candidate consolidation policy may be based on the obtained metadata. The obtaining function 210 and the further obtaining function 220 may be implemented as a common obtaining function.

The control circuitry 202 may be further configured to apply the consolidated machine learning model on a validation dataset. This may be performed e.g. by execution of an applying function 222. The evaluation criterion may then indicative of a performance of the consolidated machine learning model on the validation dataset.

It should be noted that the principles, features, aspects, and advantages of the method 100 as described above in connection with Fig. 1, are applicable also to the device 200 as described herein. In order to avoid undue repetition, reference is made to the above.

Figure 3 is a schematic illustration of a vehicle 300 in accordance with some embodiments. The vehicle 300 is equipped with an Automated Driving System (ADS) 310. As used herein, a "vehicle" is any form of motorized transport. For example, the vehicle 300 may be any road vehicle such as a car (as illustrated herein), a motorcycle, a (cargo) truck, a bus, a smart bicycle, etc.

The vehicle 300 comprises a number of elements which can be commonly found in autonomous or semi-autonomous vehicles. It will be understood that the vehicle 300 can have any combination of the various elements shown in Fig. 3. Moreover, the vehicle 300 may comprise further elements than those shown in Fig. 3. While the various elements is herein shown as located inside the vehicle 300, one or more of the elements can be located externally to the vehicle 300.

Further, even though the various elements are herein depicted in a certain arrangement, the various elements may also be implemented in different arrangements, as readily understood by the skilled person. It should be further noted that the various elements may be communicatively connected to each other in any suitable way. The vehicle 300 of Fig. 3 should be seen merely as an illustrative example, as the elements of the vehicle 300 can be realized in several different ways.

The vehicle 300 comprises a control system 302. The control system 302 is configured to carry out overall control of functions and operations of the vehicle 300. The control system 302 comprises control circuitry 304 and a memory 306. The control circuitry 302 may physically comprise one single circuitry device. Alternatively, the control circuitry 302 may be distributed over several circuitry devices. As an example, the control system 302 may share its control circuitry 304 with other parts of the vehicle. The control circuitry 302 may comprise one or more processors, such as a central processing unit (CPU), microcontroller, or microprocessor. The one or more processors may be configured to execute program code stored in the memory 306, in order to carry out functions and operations of the vehicle 300. The processor(s) may be or include any number of hardware components for conducting data or signal processing or for executing computer code stored in the memory 306. In some embodiments, the control circuitry 304, or some functions thereof, may be implemented on one or more so-called system-on-a-chips (SoC). As an example, the ADS 310 may be implemented on a SoC. The memory 306 optionally includes high-speed random access memory, such as DRAM, SRAM, DDR RAM, or other random access solid-state memory devices; and optionally includes non-volatile memory, such as one or more magnetic disk storage devices, optical disk storage devices, flash memory devices, or other non-volatile solid-state storage devices. The memory 306 may include database components, object code components, script components, or any other type of information structure for supporting the various activities of the present description.

In the illustrated example, the memory 306 further stores map data 308. The map data 308 may for instance be used by the ADS 310 of the vehicle 300 in order to perform autonomous functions of the vehicle 300. The map data 308 may comprise high-definition (HD) map data. It is contemplated that the memory 308, even though illustrated as a separate element from the ADS 310, may be provided as an integral element of the ADS 310. In other words, according to some embodiments, any distributed or local memory device may be utilized in the realization of the present inventive concept. Similarly, the control circuitry 304 may be distributed e.g. such that one or more processors of the control circuitry 304 is provided as integral elements of the ADS 310 or any other system of the vehicle 300. In other words, according to an exemplary embodiment, any distributed or local control circuitry device may be utilized in the realization of the present inventive concept.

The vehicle 300 further comprises a sensor system 320. The sensor system 320 is configured to acquire sensory data about the vehicle itself, or of its surroundings. The sensor system 320 may for example comprise a Global Navigation Satellite System (GNSS) module 322 (such as a GPS) configured to collect geographical position data of the vehicle 300. The sensor system 320 may further comprise one or more sensors 324. The one or more sensor(s) 324 may be any type of on-board sensors, such as cameras, LIDARs and RADARs, ultrasonic sensors, gyroscopes, accelerometers, odometers etc. It should be appreciated that the sensor system 320 may also provide the possibility to acquire sensory data directly or via dedicated sensor control circuitry in the vehicle 300.

The vehicle 300 further comprises a communication system 326. The communication system 326 is configured to communicate with external units, such as other vehicles (i.e. via vehicle-to-vehicle (V2V) communication protocols), remote servers (e.g. cloud servers, as further shown below in connection with Fig. 6), databases or other external devices, i.e. vehicle-to-infrastructure (V2I) or vehicle-to-everything (V2X) communication protocols. The communication system 326 may communicate using one or more communication technologies. The communication system 326 may comprise one or more antennas. Cellular communication technologies may be used for long-range communication such as to remote servers or cloud computing systems. In addition, if the cellular communication technology used have low latency, it may also be used for V2V, V2I or V2X communication. Examples of cellular radio technologies are GSM, GPRS, EDGE, LTE, 4G, 5G NR, and so on, also including future cellular solutions. However, in some solutions mid to short-range communication technologies may be used such as Wireless Local Area (LAN), e.g. IEEE 802.11 based solutions, for communicating with other vehicles in the vicinity of the vehicle 300 or with local infrastructure elements. ETSI is working on cellular standards for vehicle communication and for instance 5G is considered as a suitable solution due to the low latency and efficient handling of high bandwidths and communication channels.

The communication system 326 may further provide the possibility to send output to a remote location (e.g. remote operator or control center) by means of the one or more antennas. Moreover, the communication system 326 may be further configured to allow the various elements of the vehicle 300 to communicate with each other. As an example, the communication system may provide a local network setup, such as CAN bus, I2C, Ethernet, optical fibers, and so on. Local communication within the vehicle may also be of a wireless type with protocols such as WiFi, LoRa, Zigbee, Bluetooth, or similar mid/short range technologies.

The vehicle 300 further comprises a maneuvering system 320. The maneuvering system 328 is configured to control the maneuvering of the vehicle 300. The maneuvering system 328 comprises a steering module 330 configured to control the heading of the vehicle 300. The maneuvering system 328 further comprises a throttle module 332 configured to control actuation of the throttle of the vehicle 300. The maneuvering system 328 further comprises a braking module 334 configured to control actuation of the brakes of the vehicle 300. The various modules of the steering system 328 may receive manual input from a driver of the vehicle 300 (i.e. from a steering wheel, a gas pedal and a brake pedal respectively). However, the maneuvering system 328 may be communicatively connected to the ADS 310 of the vehicle, to receive instructions on how the various modules should act. Thus, the ADS 310 can control the maneuvering of the vehicle 300.

As stated above, the vehicle 300 comprises an ADS 310. The ADS 310 may be part of the control system 302 of the vehicle. The ADS 310 is configured to carry out the functions and operations of the autonomous functions of the vehicle 300. The ADS 310 can comprise a number of modules, where each module is tasked with different functions of the ADS 310.

The ADS 310 may comprise a localization module 312 or localization block/system. The localization module 312 is configured to determine and/or monitor a geographical position and heading of the vehicle 300, and may utilize data from the sensor system 320, such as data from the GNSS module 322. Alternatively, or in combination, the localization module 312 may utilize data from the one or more sensors 324. The localization system may alternatively be realized as a Real Time Kinematics (RTK) GPS in order to improve accuracy.

The ADS 310 may further comprise a perception module 314 or perception block/system. The perception module 314 may refer to any commonly known module and/or functionality, e.g. comprised in one or more electronic control modules and/or nodes of the vehicle 300, adapted and/or configured to interpret sensory data - relevant for driving of the vehicle 300 - to identify e.g. obstacles, vehicle lanes, relevant signage, appropriate navigation paths etc. The perception module 314 may thus be adapted to rely on and obtain inputs from multiple data sources, such as automotive imaging, image processing, computer vision, and/or in-car networking, etc., in combination with sensory data e.g. from the sensor system 320.

An object detection model for detecting and/or classifying object in the surrounding environment of the vehicle 300 (or other types of machine learning models) may be part of the ADS 310, or more specifically part of the perception module 314. Such models may be a local copy of a global model managed by a remote (of fleet) server, i.e. as part of a federated learning scheme. The vehicle 300 may be configured to perform functions and principles of the method 100 as described above. These functions may be implemented in a separate computing device provided in the vehicle, such as the device 200 described above in connection with Fig. 2. The computing device may comprise control circuitry configured to perform step of the method 100 as described above in connection with Fig. 1. Alternatively, the functions may be distributed over one or more modules, systems, or elements of the vehicle 300, as readily understood by the person skilled in the art. For example, the control circuitry 304 of the control system 302 may be configured to perform some steps of the method 100.

The localization module 312 and/or the perception module 314 may be communicatively connected to the sensor system 320 in order to receive sensor data from the sensor system 320. The localization module 312 and/or the perception module 314 may further transmit control instructions to the sensor system 320.

The ADS may further comprise a path planning module 316. The path planning module 316 is configured to determine a planned path of the vehicle 300 based on a perception and location of the vehicle as determined by the perception module 314 and the localization module 312 respectively. A planned path determined by the path planning module 316 may be sent to the maneuvering system 328 for execution.

The ADS may further comprise a decision and control module 318. The decision and control module 318 is configured to perform the control and make decisions of the ADS 310. For example, the decision and control module 318 may decide on whether the planned path determined by the path-planning module 316 should be executed or not.

It should be understood that parts of the described solution may be implemented either in the vehicle 300, in a system located external to the vehicle, or in a combination of internal and external to the vehicle; for instance in a server in communication with the vehicle, a so called cloud solution, as is further explained below in connection with Fig. 4. The different features and steps of the embodiments may be combined in other combinations than those described. Further, the elements of the vehicle 300 (i.e. the systems and modules) may be implemented in different combinations than those described herein.

Figure 4 illustrates, by way of example, a system 400 according to some embodiments. More specifically, the system 400 may be configured to implement the principles of the presently disclosed technology. The system 400 should therefore be seen as a non-limiting example of a realization of the herein disclosed aspects of the present technology. For instance, the system 400 may be configured to perform the method 100 described above in connection with Fig. 1. Thus, any features or principles described above in connection with Fig. 1 are applicable also to the system 400 as described herein, and vice versa, unless otherwise stated.

The system 400 comprises a server 402 (or remote, cloud, central, back-office, fleet, or back-end server), referred to in the following as the remote server 402 or just server 402. The server may be configured as the device 300 as described above in connection with Fig. 3. Thus, any features described in connection with the device 300 may be applicable also to the server 402. As illustrated, the server 402 may be provided in the cloud, i.e. as a cloud-implemented server. Advantageously, the server 402 may perform more computational heavy tasks, or manage and coordinate the fleet of vehicles (further described below), such as aggregating data from, or distributing data to, the different vehicles of the fleet.

The system 400 further comprises one or more vehicles 404a-c, also referred to as a fleet of vehicles 404a-c. The one or more vehicles 404a-c may be vehicles as described above in connection with Fig. 5. Thus, the one or more vehicles 404a-c may be configured to perform the method 100 (or parts of the method 100) as described in connection with Fig. 1. The fleet illustrated in Fig. 4 comprises three vehicles, a first, second and third vehicle 404a-c, by way of example. The system 400 may however comprise any number of vehicles 404a-c. In the following, reference will mainly be made to the first vehicle 404a, however the same aspects applies also to the other vehicles of the fleet of vehicles.

The one or more vehicles 404a-c are communicatively connected to the remote server 402 for transmitting and/or receiving data 406 between the vehicles and the server. The one or more vehicles 404a-c may be further communicatively connected to each other. The data 406 may be any kind of data, such as communication signals, or sensor data. More specifically, the data 406 may comprise training samples acquired by the vehicles 404a-c, or any information indicative of a determined consolidation policy, a consolidated model based on said consolidation policy, model updates provided by the vehicles, triggering conditions for what data samples to collect, etc. The communication may be performed by any suitable wireless communication protocol. The wireless communication protocol may e.g. be long range communication protocols, such as cellular communication technologies (e.g. GSM, GPRS, EDGE, LTE, 4G, 5G NR, etc.) or short to mid-ranged communication protocols, such as Wireless Local Area (LAN) (e.g. IEEE 802.11) based solutions. The sever 402 comprises a suitable memory and control circuitry, for example, one or more processors or processing circuitry, as well as one or more other components such as a data interface and transceiver. The server 402 may also include software modules or other components, such that the control circuity can be configured to execute machine-readable instructions loaded from memory to implement the steps of the method to be performed.

In the following, some ways of implementing the principles of the presently disclosed technology within the system 400 will be given. However, it is to be appreciated that these examples should not be seen as limiting, as several different ways of implementation may be possible, depending on a specific realization. For further details regarding the different steps, reference is made to Fig. 1 above, in order to avoid undue repetition.

In general, the steps of the method 100 for determining a consolidation policy for forming a consolidated machine learning model may be performed by the server 402. The server 402 may then receive a number of model updates from the fleet of vehicles. The model updates being the result of training local copies of the model in the different vehicles on. The server 402 may then form a consolidated model by consolidating the received model updates according to a candidate consolidation policy. The server 402 may then evaluate the consolidated model according to an evaluation criterion. Evaluating the consolidated model may be done with the help of the fleet of vehicles, either by performing the evaluation in the vehicles (e.g. through shadow-mode testing), or receive validation data samples therefrom (e.g. based on validation triggers transmitted to the vehicles). Alternatively, evaluating the consolidated model may be performed in the server 402, e.g. using a validation dataset.

The above-described process of the system 400 is to be understood as a non-limiting example of the presently disclosed technology for improved understanding. Further variants are apparent from the present disclosure and readily realized by the person skilled in the art. For example, the method 100 (or parts of it) may be performed locally within a vehicle 404a-c of the fleet of vehicles.

The present invention has been presented above with reference to specific embodiments. However, other embodiments than the above described are possible and within the scope of the invention. Different method steps than those described above, performing the methods by hardware or software, may be provided within the scope of the invention. Thus, according to an exemplary embodiment, there is provided a non-transitory computer-readable storage medium storing one or more programs configured to be executed by one or more processors of a vehicle control system, the one or more programs comprising instructions for performing the methods according to any one of the above-discussed embodiments. Alternatively, according to another exemplary embodiment a cloud computing system can be configured to perform any of the methods presented herein. The cloud computing system may comprise distributed cloud computing resources that jointly perform the methods presented herein under control of one or more computer program products.

It should be noted that any reference signs do not limit the scope of the claims, that the invention may be at least in part implemented by means of both hardware and software, and that the same item of hardware may represent several "means" or "units".

## Claims

1. A computer-implemented method (100) for determining a consolidation policy for forming a consolidated machine learning model from a number of local machine learning models of a fleet of vehicles equipped with an automated driving system, the method (100) comprising:

   obtaining (S102) two or more model updates from one or more vehicles of the fleet of vehicles, wherein each model update is a result of training a local machine learning model of the respective vehicle;

   consolidating (S106) the two or more model updates according to a candidate consolidation policy, thereby forming a consolidated machine learning model;

   evaluating (S110) the consolidated machine learning model according to an evaluation criterion; and

   updating (S114) the candidate consolidation policy in view of the evaluation, thereby forming an updated candidate consolidation policy.

2. The method (100) according to claim 1, wherein the steps of the method (100) are repeated for the updated candidate consolidation policy until the evaluation criterion and/or a convergence criterion is met.

3. The method (100) according to claim 2, further comprising, in response to the evaluation criterion and/or the convergence criterion being met, transmitting (S116) information indicative of the consolidated machine learning model to one or more vehicles of the fleet of vehicles.

4. The method (100) according to any one of the claims 1 to 3, wherein the candidate consolidation policy comprises a set of mixing weights, wherein each mixing weight of the set of mixing weights is associated with a model update of the two or more model updates.

5. The method (100) according to any one of the claims 1 to 4, wherein the model updates of the two or more model updates comprises updated model parameters.

6. The method (100) according to any one of the claims 1 to 5, further comprising obtaining (S104) metadata associated with each model update, and wherein updating (S114) the candidate consolidation policy is based on the obtained metadata.

7. The method (100) according to any one of the claims 1 to 6, wherein the candidate consolidation policy is updated (S114) by an optimization algorithm.

8. The method (100) according to any one of the claims 1 to 7, wherein evaluating (S110) the consolidated machine learning model comprises determining (S112) one or more evaluation metrics associated with the evaluation criterion; and wherein the candidate consolidation policy is updated (S114) based on a comparison of the one or more evaluation metrics with a respective threshold value.

9. The method (100) according to claim 8, wherein the evaluation criterion is fulfilled when the one or more evaluation metrics reaches the respective threshold value.

10. The method (100) according to any one of the claims 1 to 9, further comprising applying (S108) the consolidated machine learning model on a validation dataset, and wherein the evaluation criterion is indicative of a performance of the consolidated machine learning model on the validation dataset.

11. The method (100) according to claim 10, wherein the validation dataset is formed by:

    obtaining a validation data sample; and in response to the validation data sample fulfilling one or more validation triggers, storing the validation data sample to the validation dataset.

12. A computer program product comprising instructions, which when the program is executed by a computing device, causes the computing device to carry out the method (100) according to any one of the claims 1 to 11.

13. A device (200) for determining a consolidation policy for forming a consolidated machine learning model from a number of local machine learning models of a fleet of vehicles equipped with an automated driving system, the device (200) comprising control circuitry (202) configured to:

    obtain two or more model updates from one or more vehicles of the fleet of vehicles, wherein each model update is a result of training a local machine learning model of the respective vehicle;

    consolidate the two or more model updates according to a candidate consolidation policy, thereby forming a consolidated machine learning model;

    evaluate the consolidated machine learning model according to an evaluation criterion; and update the candidate consolidation policy in view of the evaluation, thereby forming an updated candidate consolidation policy.

14. The device (200) according to claim 13, wherein the control circuitry (202) is further configured to, in response to the evaluation criterion and/or the convergence criterion being met, transmit information indicative of the consolidated machine learning model to one or more vehicles of the fleet of vehicles.

15. The device (200) according to claim 13 or 14, wherein the control circuitry (202) is further configured to obtain metadata associated with each model update, and

wherein the candidate consolidation policy is updated based on the obtained metadata.

100

**S102**
Obtaining two or more model updates

**S104**
Obtaining metadata associated with each model update of the two or more model updates

**S106**
Consolidating the two or more model updates according to a (updated) candidate consolidation policy, thereby forming a consolidated machine learning model

**S108**
Applying the consolidated machine learning model on a validation dataset

**S110**
Evaluating the consolidated machine learning model according to an evaluation criterion

**S112**
Determining one or more evaluation metrics

Updated Candidate Consolidation Policy

Evaluation and/or convergence criterion met?

NO

YES

**S114**
Updating the candidate consolidation policy, thereby forming an updated candidate consolidation policy

**S116**
Transmitting information indicative of the consolidated machine learning model

# Fig. 1

200

Control Circuitry
202

Processor
204

Transceiver
206

Memory
208

Obtaining function
210

Consolidation function
212

Evaluation function
214

Updating function
216

Transmitting function
218

Further obtaining
function
220

Applying function
222

Fig. 2

Fig. 3

Fig. 4

Update consolidation policy

504

502

ADS_1

ADS_2

⋮

ADS_N

$w\_i$

506

Form
ADS_consolidated

508

Evaluate
ADS_consolidated

510

Fig. 5

## EUROPEAN SEARCH REPORT

**Application Number**

EP 23 21 3354

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YAO YONGTAO ET AL: "FLOW: A Scalable Multi-Model Federated Learning Framework on the Wheels", 2023 IEEE INTERNATIONAL CONFERENCE ON MOBILITY, OPERATIONS, SERVICES AND TECHNOLOGIES (MOST), IEEE, 17 May 2023 (2023-05-17), pages 11-22, XP034399074, DOI: 10.1109/MOST57249.2023.00010 [retrieved on 2023-08-15] * the whole document * | 1-15 | INV. G06N20/00 G05D1/00 |
| X | EP 4 083 871 A1 (ZENSEACT AB [SE]) 2 November 2022 (2022-11-02) * the whole document * | 1-15 | |
| X | AFAF TAIK: "Clustered Vehicular Federated Learning: Process and Optimization", IEEE TRANSACTIONS ON INTELLIGENT TRANSPORTATION SYSTEMS, [Online] vol. 23, no. 12, 17 February 2022 (2022-02-17), pages 25371-25383, XP093160631, Piscataway, NJ, USA ISSN: 1524-9050, DOI: 10.1109/TITS.2022.3149860 Retrieved from the Internet: URL:https://ieeexplore.ieee.org/abstract/document/9716076> [retrieved on 2024-05-08] * the whole document * | 1-15 | **TECHNICAL FIELDS SEARCHED (IPC)** G06N B60W G05D |

The present search report has been drawn up for all claims

| Place of search | Date of completion of the search | Examiner |
|---|---|---|
| The Hague | 8 May 2024 | Ntarlagiannis, V |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 21 3354**

This annex lists the patent family members relating to the patent documents cited in the above-mentioned European search report.
The members are as contained in the European Patent Office EDP file on
The European Patent Office is in no way liable for these particulars which are merely given for the purpose of information.

**08-05-2024**

| Patent document cited in search report | | Publication date | Patent family member(s) | | Publication date |
|---|---|---|---|---|---|
| EP 4083871 | A1 | 02-11-2022 | CN | 115269370 A | 01-11-2022 |
| | | | EP | 4083871 A1 | 02-11-2022 |
| | | | US | 2022350336 A1 | 03-11-2022 |

EPO FORM P0459

For more details about this annex : see Official Journal of the European Patent Office, No. 12/82